# EUROPÄISCHE PATENTSCHRIFT

(11) **EP 1 125 364 B1**
(45) Veröffentlichungstag und Bekanntmachung des Hinweises auf die Patenterteilung: **26.06.2002**
(21) Anmeldenummer: 99955882.8
(22) Anmeldetag: 26.10.1999
(51) Int. Cl.: H03H 9/02

(54) **OBERFLÄCHENWELLENANORDNUNG MIT ZUMINDEST ZWEI OBERFLÄCHENWELLEN-STRUKTUREN**
SURFACE ACOUSTIC WAVE ARRANGEMENT WITH AT LEAST TWO SURFACE ACOUSTIC WAVE STRUCTURES
SYSTEME A ONDES DE SURFACE PRESENTANT AU MOINS DEUX STRUCTURES A ONDES DE SURFACE

(30) Priorität: 28.10.1998 DE 19849782
(43) Veröffentlichungstag der Anmeldung: 22.08.2001
(73) Patentinhaber: EPCOS AG, 81541 München (DE)
(72) Erfinder: BAUER, Thomas, D-81739 München (DE); KOVACS, Günter, D-81667 München (DE); RÖSLER, Ulrike, D-85435 Erding (DE); RUILE, Werner, D-80636 München (DE)
(74) Vertreter: Epping Hermann & Fischer
(86) Internationale Anmeldenummer: EP9908074
(87) Internationale Veröffentlichungsnummer: WO0025423

(56) Entgegenhaltungen:
- DE-A- 4 212 517
- US-A- 4 837 476
- EBATA Y: "SUPPRESSION OF BULK-SCATTERING LOSS IN SAW RESONATOR WITH QUASI-CONSTANT ACOUSTIC REFLECTION PERIODICITY" PROCEEDINGS OF THE ULTRASONICS SYMPOSIUM,US,NEW YORK, IEEE, Bd. -, 1988, Seiten 91-96, XP000076935 in der Anmeldung erwähnt

## Beschreibung

Die Erfindung bezieht sich auf Oberflächenwellenanordnungen mit mindestens zwei in Richtung der Wellenhauptausbreitung benachbarten Oberflächenwellenstrukturen, bei denen sich die Finger der ersten Oberflächenwellen-Struktur gegenüber den Fingern der zweiten hinsichtlich ihrer Periode unterscheiden und/oder in der Phase gegeneinander verschoben sind.

Am Übergang zwischen zwei unterschiedlichen oder gegeneinander phasenverschobenen Oberflächenwellenstrukturen treten zusätzlich zu den normalen Ausbreitungsverlusten breitbandige Verluste durch teilweise Konversion der Oberflächenwelle in Volumenwellen auf. Die Konversionsverluste nehmen dabei mit steigender Metallisierungshöhe zu. Dies ist zum Beispiel aus einem Artikel von Yasuo Ebata, "SUPPRESSION OF BULK-SCATTERING LOSS IN SAW RESONATOR WITH QUASI-CONSTANT ACOUSTIC REFLECTION PERIODICITY" in Ultrasonics Symposium 1988, pp. 91-96 zu entnehmen.

Dieser Fall tritt insbesondere dann auf, wenn
- die beiden Teilgitter (Oberflächenwellenstrukturen) sich hinsichtlich Periodenlänge, Metallisierungsverhältnis und/oder Schichtdicke unterscheiden, oder
- der Abstand der beiden Oberflächenwellenstrukturen so gewählt ist, daß die beiden Teilgitter gegeneinander phasenverschoben sind.

Bei vielen Filtertechniken sind solche Abweichungen von der perfekten Periodizität für die Funktionsweise des Filters essentiell (z.B.: DMS-Filter). In der DE 42 12 517 wurde daher vorgeschlagen, den Übergang zwischen den beiden Oberflächenwellenstrukturen quasi-periodisch zu gestalten. Diese Technik erweist sich allerdings nur dann als hinreichend erfolgreich, wenn der relative Unterschied der Geschwindigkeiten der Oberflächenwelle und der störenden Volumenwelle deutlich größer ist als die relative Nutzbandbreite des Filters, wie dies z.B. bei schmalbandigen ZF-Filtern auf Quarz der Fall ist. Nur dann tritt die Störung der Ubertragungsfunktion durch die parasitäre Volumenwelle außerhalb des Durchlaßbereichs des Filters auf und stört das Filterverhalten nicht.

Für Telekomunikationsnetze nach dem EGSM Standard oder für PCS/PCN sind jedoch breitbandigere verlustarme Filter erforderlich.

Als verlustarme, breitbandige Filter mit hoher Selektion werden im HF-Bereich häufig DMS-Filter (Double Mode Surface Acoustic Wave-Filter), z.B. auf 42° rot YX-LiTaO₃ Substrat oder auf 36° rot YX-LiTaO₃ eingesetzt.

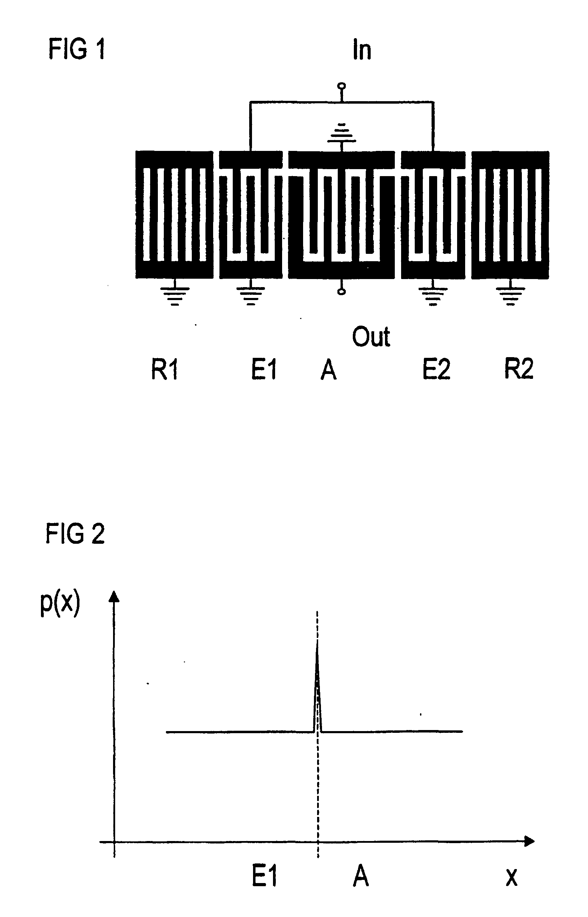

Ein Beispiel für einfache einspurige DMS-Filter ist in Fig 1 schematisch dargestellt. Dieses besteht hier aus einer Spur mit zwischen zwei Reflektoren R1 und R2 angeordneten Eingangswandlern E1 und E2 sowie dem Ausgangswandler A. Die Anschlüsse für Ein- und Ausgangswandler können auch vertauscht sein, wobei dann A den Ein- und E1,E2 die Ausgangswandler darstellen. Möglich ist auch, den oder auch die Ausgangswandler dieser einen Spur mit dem oder den Eingangswandlern einer zweiten parallelen Spur zu verbinden. Auf diese Weise kann die Selektivität des Filters erhöht werden.

DMS-Filter weisen zwei getrennte Resonanzfrequenzen innerhalb einer akustischen Spur auf, die einen Übertragungsbereich definieren. Die linke Kante des Ubertragungsbereichs wird durch die Gitterperiode bestimmt, während die rechte Kante durch Resonanz zwischen zwei gegeneinander verschobenen Oberflächenwellenstrukturen (Ein- und Ausgangswandler) zustande kommt. Diese beiden Strukturen sind im Vergleich zu einem periodischen Gitter um ein Δx von ca. λ/4 gegeneinander versetzt. Der Abstand Δx bezieht sich dabei auf die Fingermitten benachbarter (Elektroden-) Finger der Oberflächenwellenstrukturen. In der Praxis wird vorzugsweise einer der beiden Endfinger um ca. λ/4 verbreitert, wie es in der Figur 1 für den Ausgangswandler A am Übergang zu den beiden Eingangswandlern E1 und E2 dargestellt ist. Dies geschieht, um die Lücke zwischen den beiden Strukturen mit metallisierter Fläche aufzufüllen, da eine Oberflächen-Leckwelle unter metallisierter Oberfläche besser geführt wird.

Es entsteht eine Struktur mit einem stark verbreiterten Finger, der eine wesentlich größere lokale Gitterperiode p (definiert durch den Abstand der Mittelpunkte der beiden freien Flächen links und rechts vom Finger) als die übrigen Finger besitzt. Dies stellt eine erhebliche Störung des periodischen Gitters dar. Figur 2 zeigt schematisch den Verlauf der Fingerperiode p im Bereich des Übergangs zweier solcher Wandlerstrukturen (Oberflächenwellenstrukturen) über die Ortskoordinate x, der Ausbreitungsrichtung der Oberflächenwellen.

Bei bisher verwendeten Mobilfunksystemen (z.B. GSM, Nominalbandbreite 25 MHz) sind die akustischen Verluste in Form von Volumenwellenabstrahlung an den Strukturübergängen zwar bereits erkennbar, aber noch nicht so stark ausgeprägt, so daß die Realisierung verlustarmer Filter möglich ist. In zukünftigen Mobilfunksystemen werden jedoch breitere Bänder genutzt werden, um mehr Kanäle zur Verfügung zu stellen (z.B. EGSM, Nominalbandbreite 35 MHz).

Zur Erhöhung der Bandbreite von Oberflächenwellenfilter werden gewöhnlich die Metallisierungs-Schichtdicken vergrößert und die Fingerzahlen reduziert. Beide Maßnahmen vergrößern die Verluste an den Übergängen zwischen den Strukturen. In der Praxis äußern sich diese Verluste in einer Verringerung der Güte der Wandler/Wandler-Resonanz, die die rechte Bandkante definiert, und somit in einem Einbruch im oberen Passbandbereich.

Speziell bei EGSM-Filtern ist der Einfluß der Verluste so groß, daß durch zusätzliche äußere Anpassungselemente der Einbruch im oberen Durchlaßbereich ausgeglichen werden muß. Durch die externe Anpassung kann zwar die Welligkeit im Durchlaßbereich verringert werden, es bleibt aber als wesentlicher Nachteil die erhöhte Einfügedämpfung solcher Filter durch die Verluste an den Übergängen. Die z.B. für EGSM geforderte Spezifikation kann auch nur teilweise erfüllt werden. Äußere Anpaßnetzwerke sind außerdem immer mit zusätzlichen Kosten, Gewicht, Fläche auf der Schaltung und Fertigungsaufwand verbunden und bei den meisten Anwendern daher unerwünscht.

Aufgabe der vorliegenden Erfindung ist es daher, verlustarme breitbandige Filter zu schaffen, die die oben angeführten Nachteile vermeiden.

Diese Aufgabe wird erfindungsgemäß mit einer Oberflächenwellenanordnung nach Anspruch 1 gelöst. Weitere Ausgestaltungen der Erfindung gehen aus den Unteransprüchen hervor.

Mit der Erfindung werden die Übertragungsverluste des Filters gesenkt, was sich in der verbesserten Einfügedämpfung und vor allem in der oberen Hälfte des Passbandes bemerkbar macht. Die nutzbare Bandbreite wird dadurch vergrößert. Auf externe Anpaßnetzwerke kann verzichtet werden.

Beim Entwurf breitbandiger, verlustarmer Oberflächenwellenfilter (z.B. HF-Filter für EGSM oder PCS/PCN auf 42° rot YX-LiTaO₃) wurde von den Erfindern erkannt, daß auch in einem quasi-periodischen Gitter zusätzliche Verluste in Form von Konversion in Volumenwellen auftreten, wenn die lokale Periode am Übergang größer ist als in den beiden Strukturen beiderseits des Übergangs. Im Gegensatz zu einem harten Übergang mit abrupt erhöhter Fingerperiode tritt diese Konversion jedoch erst ab einer charakteristischen Onsetfrequenz auf, die umgekehrt proportional zur lokalen Periode des Gitters ist.

Die Verluste an den Übergängen zwischen Oberflächenwellenstrukturen mit unterschiedlicher Phase und/oder unterschiedlicher Fingerperiode werden daher erheblich reduziert bzw. ganz vermieden, indem an den Übergangsstellen erfindungsgemäß eine Fingerperiode verwendet wird, die unterhalb der Fingerperiode der benachbarten Oberflächenwellenstrukturen liegt. Damit wird erreicht, daß die Onset-frequenz für Volumenwellenabstrahlung oberhalb des gewünschten Übertragungsbereiches des Filters liegt. Der Übergang zwischen den Oberflächenwellenstrukturen ist quasi-periodisch, d.h. im Bereich des Wellenübergangs zwischen zwei Oberflächenwellen-Strukturen wird eine quasiperiodische Struktur ausgebildet, die einen stetigen Übergang der Fingerperiode p und/oder der Phase der ersten Oberflächenwellenstruktur in diejenige der zweiten Oberflächenwellenstruktur bildet.

Je nach Ausmaß der Diskontinuität am Übergang wird ein quasiperiodischer Übergangsbereich mit einer hinreichend großen Fingerzahl gebildet. Selbst für stärkste Diskontinuitäten erweist sich eine Anzahl von 3-4 endständigen Fingern pro Oberflächenwellenstruktur als ausreichend zur Unterdrückung der verluste. Der Übergangsbereich sollte nicht größer als zur Vermeidung von Verlusten notwendig gewählt werden, da sonst das Ubertragungsverhalten des Filters negativ beeinflußt wird.

Der gewünschte erfindungsgemäße Übergang wird erreicht, wenn die Fingerperiode der ersten Oberflächenwellenstruktur im Übergangsbereich zunächst kontinuierlich abnimmt und schließlich wieder kontinuierlich ansteigt, bis die Fingerperiode der zweiten Oberflächenwellenstruktur erreicht ist.

Unter Oberflächenwellenstruktur im Sinne der Erfindung werden sowohl Interdigitalwandler als auch Reflektoren verstanden. Übergänge können daher sowohl zwischen zwei Interdigitalwandlern als auch zwischen einem Interdigitalwandler und einem Reflektor sowie zwischen zwei Reflektoren auftreten und erfindungsgemäß ausgestaltet sein. Vorteilhaft kann die Erfindung daher insbesondere bei DMS-Filtern und Eintorresonatoren eingesetzt werden. Bei Letzteren weisen die Reflektoren eine andere (größere) Fingerperiode auf, als der Interdigitalwandler.

Zur Verringerung der Fingerperiode im Übergangsbereich werden Fingerbreite und Fingerabstand kontinuierlich reduziert.

Die Wahl eines Metallisierungsverhältnisses η (η = Verhältnis der metallisierten zur unmetallisierten Fäche innerhalb einer Periode der Oberflächenwellenstruktur) zwischen 0,7 und 0,8 reduziert die Geschwindigkeit der Oberflächen-Leckwelle, wodurch sich der Abstand der Onset-frequenz für Volumenwellenkonversion zum Passband weiter vergrößert. Somit verringert sich auch der Einfluß der Volumenwellenverluste.

Ebenfalls geringere Ubertragungsverluste werden erzielt, wenn die Reflektoren der Oberflächenwellenanordnung mit Masse verbunden werden, da dadurch der verlustbehaftete Ladungsaustausch innerhalb des Reflektors deutlich verringert wird.

Im folgenden wird die Erfindung anhand von Ausführungsbeispielen und der dazugehörigen fünf Figuren näher erläutert.
- Figur 1: zeigt ein bekanntes Einspur-DMS-Filter.
- Figur 2: gibt den Verlauf der Fingerperiode des bekannten Filters (siehe Figur 1) entlang der Ortskoordinate wieder.
- Figur 3: zeigt den Verlauf der Fingerperiode bei einer erfindungsgemäßen Oberflächenwellenanordnung.
- Figur 4a: zeigt zwei Oberflächenwellenstrukturen mit hartem Übergang, denen in
- Figur 4b: eine Oberflächenwellenanordnung mit erfindungsgemäßem Übergang zwischen zwei Oberflächenwellenstrukturen gegenübergestellt ist.
- Figur 5: zeigt das Durchlaßverhalten erfindungsgemäßer und bekannter Filter im Vergleich anhand von Meßkurven.

Figur 1 zeigt ein bekanntes Einspur-DMS-Filter, bei dem zwischen zwei Reflektoren R1 und R2 zwei parallel geschaltene Eingangswandler E1, E2 und dazwischen ein Ausgangswandler A angeordnet ist. Mit In und Out sind die elektrischen Anschlüsse für Ein- und Ausgang bezeichnet. Die Fingerperiode p, die ein Maß für die Abstände der Finger darstellt, wird im folgenden als die Entfernung definiert, die von der Mitte des Freiraums zwischen zwei Fingern zur Mitte des nächsten Freiraums zwischen zwei benachbarten Fingern reicht. Im dargestellten DMS-Filter ist der Ausgangswandler A gegenüber den beiden Eingangswandlern E1 und E2 verschoben, wobei die Fingerperiode jeweils am Übergang E1/A bzw. A/E2 zwischen zwei gegeneinander verschobenen Wandlern eine Unstetigkeit aufweist.

Figur 2 zeigt den Verlauf der Fingerperiode für diesen Wandler im Bereich des Übergangs vom Wandler E1 zum Wandler A. Die Verschiebung der beiden Wandler gegeneinander äußert sich in einer abrupt ansteigenden Fingerperiode, die anschließend ebenso abrupt wieder auf einen konstanten Wert abfällt. Der gleiche harte Übergang ist zwischen den beiden gegeneinander verschobenen Wandlern A und E2 zu beobachten. Die beiden äußeren Endfinger des Wandlers A sind verbreitert, um die Lücke zwischen den beiden Strukturen mit metallisierter Fläche auszufüllen. Die Nachteile, die aus einem solchen unstetigen Verlauf der Fingerperiode am Übergang zwischen zwei Oberflächenwellenstrukturen (hier zwei Wandlern) entstehen, wurden eingangs bereits erläutert.

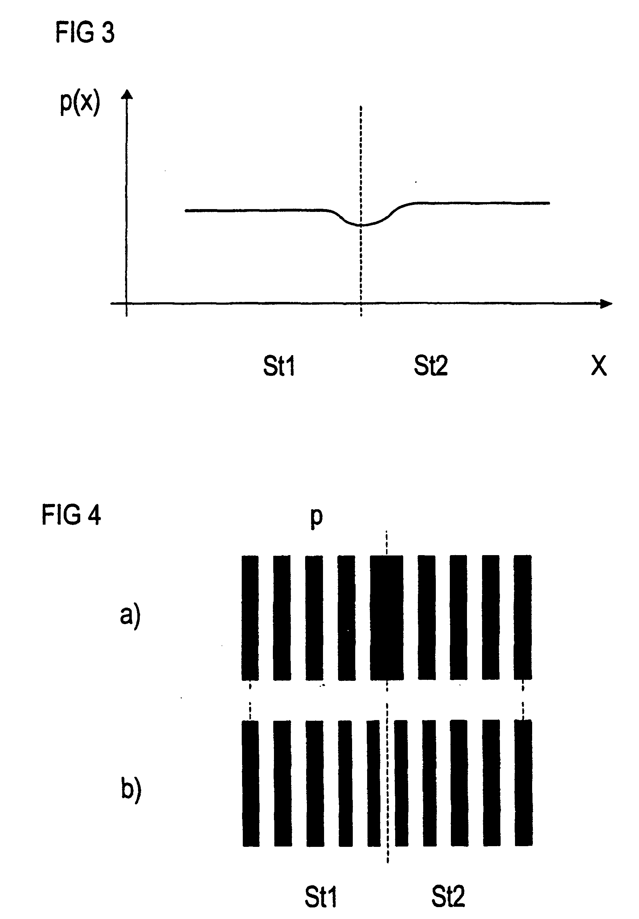

Figur 3 zeigt den Verlauf der Fingerperiode p bei einer erfindungsgemäßen Oberflächenwellenanordnung im Bereich des Übergangs einer ersten Oberflächenwellenstruktur St1 zu einer zweiten Oberflächenwellenstruktur St2. Die Fingerperiode p verändert sich im Bereich des Übergangs stetig und weist dort auch einen niedrigeren Wert auf als in jeder der beiden Strukturen St1 und St2. Außerhalb des Übergangsbereichs, also innerhalb der beiden Strukturen St1 und St2 nimmt die Fingerperiode einen konstanten Wert an, der von Oberflächenwellenstruktur zu Oberflächenwellenstruktur unterschiedlich sein kann. Die Oberflächenwellenstruktur kann dabei ein Interdigitalwandler oder ein Reflektor sein, wobei der Übergang zwischen Wandler und Wandler oder zwischen Wandler und Reflektor stattfinden kann.

Figur 4 zeigt anhand eines Ausführungsbeispiels, wie der Übergang zwischen zwei gegeneinander verschobenen Oberflächenwellenstrukturen St1 und St2 erfindungsgemäß ausgestaltet werden kann. Figur 4a zeigt zum Vergleich einen bekannten harten Übergang, wie er bereits anhand von Figur 1 dargestellt wurde. Dabei ist einer der beiden Grenzfinger verbreitert. Figur 4b zeigt den erfindungsgemäß ausgestalteten Übergang. Die Fingerperiode p wird hier über die letzten drei Finger der Struktur St1 kontinuierlich abgesenkt und steigt in der benachbarten Struktur St2 über die äußersten drei Finger ebenso kontinuierlich wieder an. Durch diese Anordnung werden die Streuverluste am Übergang der beiden Strukturen gegenüber einer bekannten Anordnung mit hartem Übergang deutlich reduziert.

Außerdem ist ein beispielsweise gemäß Figur 4b erfindungsgemäß ausgestalteter Übergang herstellerfreundlich, da sowohl Fingerbreiten als auch Fingerabstände nicht zu stark von "normalen" Fingerbreiten und Fingerabständen abweichen.

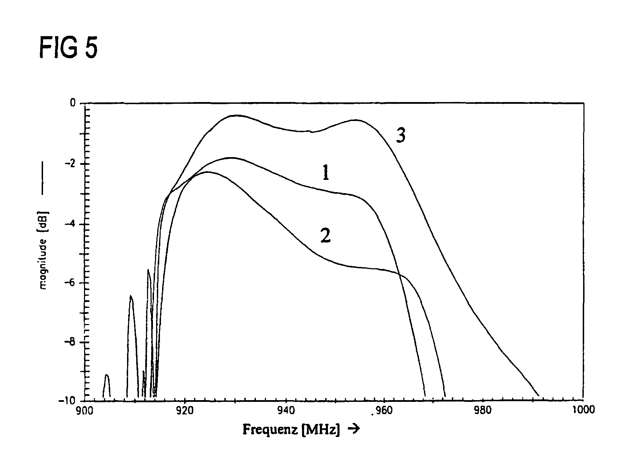

Figur 5 zeigt die Durchlaßkurven dreier Oberflächenwellenfilter, die gegeneinander verschobene Oberflächenwellenstrukturen aufweisen. Als Beispiel dient das in Figur 1 dargestellte DMS-Filter, dessen Durchlaßverhalten durch die Durchlaßkurve 1 in Figur 5 dargestellt ist. Die Durchlaßkurve 2 wird bei einem DMS-Filter gemäß Figur 1 erhalten, das jedoch einen stetigen Verlauf der Fingerperiode aufweist. Bei dieser Struktur ist der endständige Finger nicht verbreitert, der höhere Abstand zwischen den beiden Strukturen beiderseits des Übergangs ist jedoch über die jeweils äußersten drei Finger verteilt, so daß eine lokal erhöhte Fingerperiode am Übergang entsteht. Wie aus der Meßkurve 2 klar zu erkennen ist, weist ein so ausgestaltetes DMS-Filter ein noch schlechteres Durchlaßverhalten als das in Figur 1 dargestellte Filter auf. Die Durchlaßkurve 3 dagegen wird mit einem erfindungsgemäß ausgestalteten DMS-Filter gemessen, bei dem die Fingerperiode im Bereich des Übergangs der beiden gegeneinander verschobenen Wandler (Oberflächenwellenstrukturen) erniedrigt ist, wobei gegenüber dem aus Figur 1 bekannten OFW-Filter ein zusätzlicher Finger eingefügt ist. Zum Übergang hin nehmen dabei in beiden Wandlern sowohl Fingerbreite als auch Fingerabstand kontinuierlich ab. Wie Figur 5 zeigt, besitzt ein solches erfindungsgemäß ausgestaltetes Filter ein besseres Übertragungsverhalten, das durch eine geringere Dämpfung und eine gleichmäßigere Durchlaßkurve gekennzeichnet ist. Die geringere Dämpfung insbesondere im Bereich der rechten Kante der Durchlaßkurve wird durch die geringeren Streuverluste im Bereich des Übergangs erzielt.

Als Ausführungsbeispiel werden im folgenden weitere Parameter zur Realisierung von DMS-Filtern angegeben, die für das EGSM-System geeignet sind, das bei einer Mittenfrequenz von 942,5 MHz eine Nominalbandbreite von 35 MHz aufweist.

Als Substrat wird Lithiumtantalat LiTaO₃ mit 42° Rot YX-Kristallschnitt verwendet. Die Metallisierung für die Oberflächenwellenstrukturen wird in einer Höhe aufgebracht, die 9 bis 11 Prozent der dazugehörigen Wellenlänge, beispielsweise 420 nm beträgt. Damit wird die geforderte Bandbreite von 35 MHz realisiert. Die rechte Flanke der Durchlaßkurve des Filters, die durch die Resonanz zwischen zwei um einen Wert Δx gegeneinander verschobenen Wandlern erzeugt wird, kann den EGSM-Spezifikationen entsprechend eingestellt werden, wenn Δx = (0,25 ± 0,05)λ gewählt wird. Der quasi-periodische Übergang der Fingerperiode zwischen den beiden verschobenen Wandlern kann auf insgesamt fünf bis acht Finger verteilt werden. Die Gesamtzahl der Elektrodenfinger im Wandler A (siehe Figur 1) wird vorzugsweise im Bereich von 27 bis 35, und die Anzahl der Finger in den Wandlern E1 und E2 im Bereich von 20 bis 24 gewählt. Damit wird ein bezüglich Welligkeit und Flankensteilheit optimiertes Filter erhalten.

Die für das EGSM geforderte Selektion wird bei einem Filter mit zwei am Übergang erfindungsgemäß ausgestalteten Spuren erhalten. Die Apertur wird zwischen 50 x λ und 70 x λ gewählt, um Ein- und Ausgangsimpedanzen von 50Ω zu erhalten.

Ein Gesamtfilter mit erfindungsgemäßer Oberflächenwellenanordnung kann auch Ausführungsformen betreffen, die symmetrisch/unsymmetrisch betreibbar sind. Darunter versteht man einen Filter, bei dem entweder am Ein- oder am Ausgang ein unsymmetrisches Signal anliegt, das heißt, bei dem einer der beiden Anschlüsse signalführend ist, während der andere auf Masse liegt. Am anderen Ende des Filters liegt an den beiden Anschlüssen ein symmetrisches Signal vor, welches an beiden Anschlüssen zwar die gleiche absolute Amplitude jedoch entgegengesetztes Vorzeichen bzw. einen Phasenunterschied von 180° aufweist.

Eine weitere Anwendung findet die Erfindung bei symmetrisch unsymmetrisch betreibbaren DMS-Filtern, bei denen Ein- und Ausgangsimpedanz unterschiedlich sind. Die Einstellung der Ein- oder Ausgangsimpdedanz kann durch Wichtung erfolgen oder durch vertikale oder horizontale Aufteilung der Wandler in Teilwandlerstrukturen vorgenommen werden, wie es beispielsweise in den beiden älteren deutschen Patentanmeldungen 197 24 258.8 und 197 24 259.6 vorgeschlagen wird.

Möglich ist es auch, wenn die Abstände zwischen dem mittleren Interdigitalwandler (A) und den beiden äußeren Interdigitalwandlern (E1,E2) unterschiedlich groß sind.

Eine weitere Ausgestaltung betrifft ein Filter, das als Zweispuranordnung ausgebildet ist, wobei die Fingerperioden p der Reflektoren (R) in den beiden Spuren unterschiedlich groß sind.

Ebenso kann die Erfindung in einem Resonatorfilter verwirklicht werden, bei dem der Übergang zwischen gegeneinander verschobenem Wandler und Reflektor erfindungsgemäß ausgestaltet ist. Zum Beispiel kann ein Reaktanzfilter aus mehreren serielll und/oder parallel verschalteten Eintorresonatoren mit einem Übergang zwischen den unterschiedlichen Fingerperioden (p) von Interdigitalwandler und Reflektor in zumindest einem Eintorresonator ausgebildet sein

## Patentansprüche

1. Oberflächenwellenanordnung mit folgenden Merkmalen
- einem piezoelektrischen Substrat,
- auf dem Substrat aufgebrachten, in Ausbreitungsrichtung der Oberflächenwellen hintereinander angeordneten, aus metallischen Fingern bestehenden ersten und zweiten Oberflächenwellenstrukturen (St1,St2) mit einer ersten bzw. zweiten Fingerperiode (p),
- die beiden Oberflächenwellenstrukturen weisen unterschiedliche Phase und/oder unterschiedliche Fingerperiode (p) auf
- endständige Finger der beiden Oberflächenwellenstrukturen bilden einen Übergangsbereich von der ersten auf die zweite Oberflächenwellenstruktur, **dadurch gekennzeichnet, daß**
- die lokale Fingerperiode (p) der ersten Oberflächenwellenstruktur nimmt im Übergangsbereich zunächst kontinuierlich ab und steigt schließlich wieder kontinuierlich an, bis die Fingerperiode der zweiten Oberflächenwellenstruktur erreicht ist.

2. Oberflächenwellenanordnung nach Anspruch 1,
bei der der Übergangsbereich von 5 bis 8 endständigen Fingern der beiden Oberflächenwellenstrukturen gebildet wird.

3. Oberflächenwellenanordnung nach Anspruch 1 oder 2,
bei dem zumindest eine der beiden Oberflächenwellenstrukturen als Interdigitalwandler (A, E) ausgebildet ist.

4. Oberflächenwellenanordnung nach Anspruch 3,
bei der die zweite Oberflächenwellenstrukturen als Reflektor ausgebildet (R) ist.

5. Oberflächenwellenanordnung nach Anspruch 1 oder 2,
bei dem die beiden Oberflächenwellenstrukturen als Reflektoren (R) ausgebildet sind.

6. Oberflächenwellenanordnung nach einem der Ansprüche 1 - 5,
bei der die Breite der Finger der Oberflächenwellenstrukturen im Übergangsbereich zunächst ab- und dann wieder zunimmt.

7. Oberflächenwellenanordnung nach einem der Ansprüche 1 - 6,
bei dem die Oberflächenwellenstrukturen ein Metallisierungsverhältnis η von 0,7 bis 0,8 aufweisen.

8. Oberflächenwellenanordnung nach einem der Ansprüche 1 - 7,
welches als Dual-Mode-Oberflächenwellen-Filter (DMS-Filter) ausgebildet ist, wobei in einer akustischen Spur als Einbzw- Ausgangswandler dienende Interdigitalwandler zwischen zwei Reflektoren angeordnet sind und die Oberflächenwellenstrukturen aus Interdigitalwandler und Reflektoren ausgewählt sind.

9. Oberflächenwellenanordnung nach Anspruch 8,
bei der die Reflektoren mit Masse verbunden sind.

10. Oberflächenwellenanordnung nach Anspruch 8 oder 9,
bei der die Metallisierungshöhe der Oberflächenwellenstrukturen im Bereich von 9-11% der der Oberflächenwellenstrukturen zugehörigen Wellenlänge der akustischen Oberflächenwellen liegt.

11. Anordnung nach einem der Ansprüche 1 bis 10,
angeordnet auf 42° rot YX-LiTaO₃ Substrat oder auf 36° rot YX-LiTaO₃.

12. Anordnung nach einem der Ansprüche 1 bis 11,
mit drei Interdigitalwandlern (A,E1,E2) die hintereinander zwischen zwei Reflektoren (R1,R2) angeordnet sind, wobei der mit einem ersten Anschluß (OUT) verbundene mittlere Interdigitalwandler eine Anzahl von 27 bis 35 Elektrodenfinger, die beiden äußeren, mit einem zweiten Anschluß (IN) verbundenen Interdigitalwandler (E1,E2) dagegen eine Anzahl 20 bis 24 Elektrodenfinger aufweisen.

13. Anordnung nach Anspruch 12,
bei der die Abstände zwischen dem mittleren Interdigitalwandler (A) und den beiden äußeren Interdigitalwandlern (E1,E2) unterschiedlich groß sind.

14. Anordnung nach einem der Ansprüche 1 - 13,
die als Zweispuranordnung ausgebildet ist, wobei die Fingerperioden p der Reflektoren (R) in den beiden Spuren unterschiedlich groß sind.

15. Anordnung nach einem der Ansprüche 1 - 7,
die als Reaktanzfilter mit Eintorresonatoren ausgebildet ist, mit einem Übergang zwischen den unterschiedlichen Fingerperioden (p) von Interdigitalwandler und Reflektor in zumindest einem Eintorresonator.

## Claims

1. Surface acoustic wave arrangement having the following features:
- a piezoelectric substrate
- first and second surface acoustic wave structures (St1, St2) which are fitted on the substrate, are arranged one behind the other in the propagation direction of the surface acoustic waves, comprise metallic fingers and have a first and second finger period (p), respectively,
- the two surface acoustic wave structures have a different phase and/or a different finger period (p),
- end of fingers of the two surface acoustic wave structures from a transitional region from the first to the second surface acoustic wave structure, **characterized in that**
- the local finger period (p) of the first surface acoustic wave structure initially decreases continuously in the transitional region and, finally, increases continuously again, until the finger period of the second surface acoustic wave structure is reached.

2. Surface acoustic wave arrangement according to Claim 1,
in which the junction region is formed by 5 to 8 fingers at the ends of the two surface acoustic wave structures.

3. Surface acoustic wave arrangement according to Claim 1 or 2,
in which at least one of the two surface acoustic wave structures is in the form of an interdigital transducer (A, E).

4. Surface acoustic wave arrangement according to Claim 3,
in which the second surface acoustic wave structures [sic] is in the form of a reflector (R).

5. Surface acoustic wave arrangement according to Claim 1 or 2,
in which the two surface acoustic wave structures are in the form of reflectors (R).

6. Surface acoustic wave arrangement according to one of Claims 1-5,
in which the width of the fingers of the surface acoustic wave structures initially decreases and then increases again in the junction region.

7. Surface acoustic wave arrangement according to one of Claims 1-6,
in which the surface acoustic wave structures have a metallization ratio η of 0.7 to 0.8.

8. Surface acoustic wave arrangement according to one of Claims 1-7,
which is in the form of a dual mode surface acoustic wave filter (DMS filter), with interdigital transducers which are used as input and output transducers being arranged between two reflectors in one acoustic track, and the surface acoustic wave structures being selected from interdigital transducers and reflectors.

9. Surface acoustic wave arrangement according to Claim 8,
in which the reflectors are connected to ground.

10. Surface acoustic wave arrangement according to Claim 8 or 9,
in which the metallization height of the surface acoustic wave structures is in the region from 9-11% of the wavelength, which is associated with the surface acoustic wave structures, of the surface acoustic waves.

11. Arrangement according to one of Claims 1 to 10, arranged on a 42° red YX-LiTaO₃ substrate or on a 36° red YX-LiTaO₃.

12. Arrangement according to one of Claims 1 to 11, having three interdigital transducers (A, E1, E2) which are arranged one behind the other between two reflectors (R1, R2), with the central interdigital transducer, which is connected to a first connection. (OUT), having a total of 27 to 35 electrode fingers while, in contrast, the two outer interdigital transducers (E1, E2), which are connected to a second connection (IN), have a total of 20 to 24 electrode fingers.

13. Arrangement according to Claim 12,
in which the distances between the central interdigital transducer (A) and the two outer interdigital transducers (E1, E2) are of different magnitude.

14. Arrangement according to one of Claims 1-13,
which is in the form of a two-track arrangement, with the finger periods (p) of the reflectors (R) in the two tracks being of different magnitude.

15. Arrangement according to one of Claims 1-7,
which is in the form of a reactance filter with single-port resonators, with a junction between the different finger periods (p) of an interdigital transducer and a reflector in at least one single-port resonator.

## Revendications

1. Dispositif à ondes de surface ayant les caractéristiques suivantes :
- un substrat piézo-électrique,
- des première et deuxième structures (St1, St2) à ondes de surface déposées sur le substrat, disposées l'une derrière l'autre dans la direction de propagation des ondes de surface, constituées de doigts métalliques et ayant une première et deuxième périodes (p) des doigts,
- les deux structures à ondes de surface ont des phases différentes et/ou des périodes (p) de doigts qui sont différentes,
- des doigts d'extrémité des deux structures à ondes de surface forment une zone de transition, de la première structure à ondes de surface à la deuxième structure à ondes de surface, **caractérisé en ce que**
- la période (p) locale des doigts de la première structure à ondes de surface diminue d'abord continûment dans la zone de transition, puis augmente finalement à nouveau d'une manière continue, jusqu'à ce que la période des doigts de la deuxième structure à ondes de surface soit atteinte.

2. Dispositif à ondes de surface suivant la revendication 1, dans lequel la zone de transition est formée de 5 à 8 doigts d'extrémité des deux structures à ondes de surface.

3. Dispositif à ondes de surface suivant la revendication 1 ou 2, dans lequel au moins l'une des deux structures à ondes de surface est constituée en convertisseur (A, E) interdigité.

4. Dispositif à ondes de surface suivant la revendication 3, dans lequel la deuxième structure à ondes de surface est constituée (R) en réflecteurs.

5. Dispositif à ondes de surface suivant la revendication 1 ou 2, dans lequel les deux structure à ondes de surface sont constituées en réflecteurs (R).

6. Dispositif à ondes de surface suivant l'une des revendications 1 à 5, dans lequel la largeur des doigts des structures à ondes de surface dans la zone de transition, diminue d'abord, puis réaugmente.

7. Dispositif à ondes de surface suivant l'une des revendications 1 à 6, dans lequel les structures à ondes de surface ont un rapport de métallisation η de 0,7 à 0,8.

8. Dispositif à ondes de surface suivant l'une des revendications 1 à 7, qui est constitué en filtre à ondes de surface en mode Dual (filtre DMS), un convertisseur interdigité, servant de convertisseur d'entrée ou de convertisseur de sortie dans une piste acoustique, étant interposé entre deux réflecteurs et les structures à ondes de surface étant sélectionnées parmi des convertisseurs interdigités et des réflecteurs.

9. Dispositif à ondes de surface suivant la revendication 8, dans lequel les réflecteurs sont reliés à la masse.

10. Dispositif à ondes de surface suivant la revendication 8 ou 9, dans lequel le niveau de métallisation des structures à ondes de surface, est de l'ordre de 9 à 11 % des longueurs d'ondes de surface acoustique, associées aux structures à ondes de surface.

11. Dispositif à ondes de surface suivant l'une des revendications 1 à 10, disposé sur un substrat en LiTaO₃ à rotation YX de 42° ou sur du LiTaO₃ à rotation YX de 36°.

12. Dispositif à ondes de surface suivant l'une des revendications 1 à 11, comprenant trois convertisseurs (A, E1, E2) interdigités qui sont disposés les uns derrière les autres entre deux réflecteurs (R1, R2), le convertisseur interdigité médian étant relié à une première borne (OUT) et ayant un nombre de 27 à 35 doigts d'électrodes, tandis que les deux convertisseurs (E1, E2) interdigités extérieurs sont reliés à une deuxième borne (IN) et ont un nombre de 20 à 24 doigts d'électrodes.

13. Dispositif à ondes de surface suivant la revendication 12, dans lequel les intervalles entre le convertisseur (A) interdigité médian et les deux convertisseurs (E1, E2) interdigités extérieurs sont différents.

14. Dispositif à ondes de surface suivant l'une des revendications 1 à 13, qui est constitué en dispositif à deux pistes, les périodes (p) de doigts des réflecteurs (R) étant différentes dans les deux pistes.

15. Dispositif à ondes de surface suivant l'une des revendications 1 à 7, qui est constitué en filtre de réactance à résonateurs à une seule porte, ayant une transition entre les périodes (p) différentes de doigts de convertisseurs interdigités et de réflecteur en au moins un résonateur à une seule porte.
